# EUROPÄISCHE PATENTSCHRIFT

(11) **EP 2 289 109 B1**
(45) Veröffentlichungstag und Bekanntmachung des Hinweises auf die Patenterteilung: **21.03.2012**
(21) Anmeldenummer: 09742037.6
(22) Anmeldetag: 05.05.2009
(51) Int. Cl.: H01L 31/0224

(54) **VERFAHREN ZUR HERSTELLUNG EINER MONOKRISTALLINEN SOLARZELLE**
METHOD FOR PRODUCING A MONOCRYSTALLINE SOLAR CELL
PROCÉDÉ DE FABRICATION D'UNE CELLULE SOLAIRE MONOCRISTALLINE

(30) Priorität: 07.05.2008 DE 102008022574; 15.07.2008 DE 102008033169
(43) Veröffentlichungstag der Anmeldung: 02.03.2011
(73) Patentinhaber: Robert Bosch GmbH, 70469 Stuttgart (DE)
(72) Erfinder: KROKOSZINSKI, Hans-Joachim, 69226 Nußloch (DE); MEYER, Karsten, 99084 Erfurt (DE)
(86) Internationale Anmeldenummer: PCT/EP2009/055372
(87) Internationale Veröffentlichungsnummer: WO 2009/135819

(56) Entgegenhaltungen:
- EP-A1- 1 763 086
- WO-A2-2006/029250
- JP-A- 2005 101 240
- US-A1- 2004 200 520
- BLAKERS A W ET AL: "22.8% EFFICIENT SILICON SOLAR CELL" APPLIED PHYSICS LETTERS, AIP, AMERICAN INSTITUTE OF PHYSICS, MELVILLE, NY, US LNKD- DOI:10.1063/1.101596, Bd. 55, Nr. 13, 25. September 1989 (1989-09-25), Seiten 1363-1365, XP000081976 ISSN: 0003-6951
- KNOBLOCH J ET AL: "COST EFFECTIVE PROCESSES FOR SILICON SOLAR CELLS WITH HIGH PERFORMANCE" 9TH. E.C. PHOTOVOLTAIC SOLAR ENERGY CONFERENCE. FREIBURG, GERMANY, SEPT. 25 - 29, 1989; [PROCEEDINGS OF THE INTERNATIONAL PHOTOVOLTAIC SOLAR ENERGY CONFERENCE], DORDRECHT : KLUWER ACADEMIC PUBLISHERS, NL, Bd. CONF. 9, 25. September 1989 (1989-09-25), Seiten 777-780, XP001135503 ISBN: 978-0-7923-0497-5
- SCHNEIDERLOECHNER E ET AL: "LASER-FIRED REAR CONTACTS FOR CRYSTALLINE SILICON SOLAR CELLS" PROGRESS IN PHOTOVOLTAICS. RESEARCH AND APPLICATIONS, JOHN WILEY AND SONS, CHICHESTER, GB LNKD- DOI:10.1002/PIP.422, Bd. 10, Nr. 1, 1. Januar 2002 (2002-01-01) , Seiten 29-34, XP001112408 ISSN: 1062-7995

## Beschreibung

Die Erfindung betrifft ein Verfahren zur Herstellung einer monokristallinen Solarzelle mit einer passivierten Rückseite und einer Rückseitenkontaktstruktur sowie eine derartige verfahrensgemäß hergestellte Zelle.

Es ist bekannt, Silizium-Solarzellen mit einer passivierenden Antireflexschicht auf der vorderseitigen n-Emitterschicht rückseitig mit einer ganzflächigen Metallisierung des Basisbereichs zur Verspiegelung und zur Bandverbiegung (Back Surface Field - BSF) auf der Rückseite zu versehen.

Eine solche Rückseitenmetallisierung besteht üblicherweise aus großflächig aufgedruckter, Aluminium-basierter Dickschichtpaste, die sich beim Sintern oberhalb von 800° durch Bildung des niederschmelzenden AlSi-Eutektikums und Rekristallisation an die Halbleiteroberfläche anlegiert und dabei die vorhandene n-Dotierung aufgrund einer vorher erfolgten Phosphordiffusion zur p⁺-Dotierung überkompensiert.

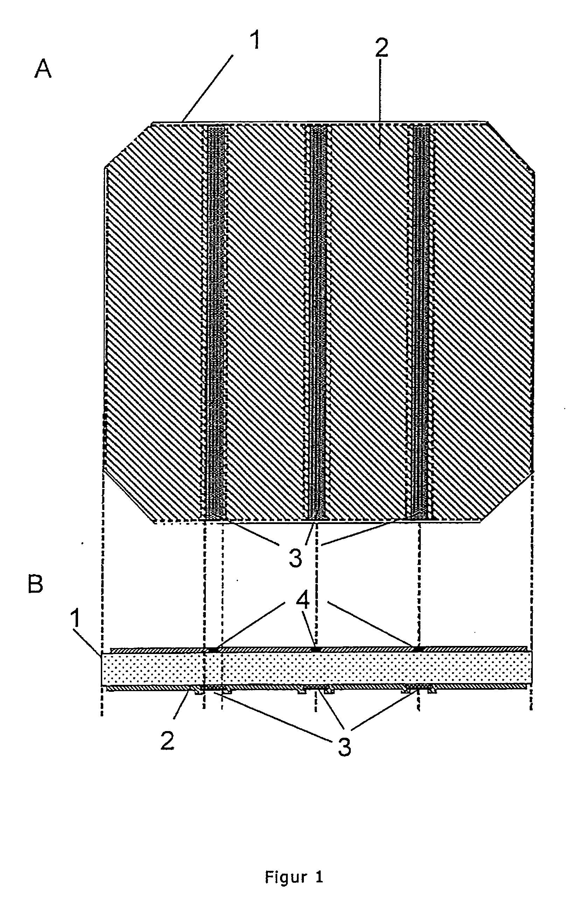

Da für die Modulintegration von Zellen auch lötfähige Kontakte auf der Rückseite notwendig sind, ist es erforderlich, vorher einen Druck mit Silberbasierter Paste aufzubringen, wobei der Druck üblicherweise die Zahl und die Position vorhandener Busbars der Vorderseite auf der Rückseite reproduziert. Eine derartige Zelle des Standes der Technik ist in der Prinzipdarstellung nach Fig. 1 gezeigt. Die Rückseitenbusbars werden in streifenförmige Bereiche unterhalb der Vorderseitenbusbars gedruckt, bevor der abschließende Alumiumpastendruck die verbleibenden Flächen seitlich der Busbars füllt, wobei sich Aluminium und Silber entlang der Kanten jedes Silberstreifens leicht überlappen.

Es wurde weiterhin vorgeschlagen, die Dickschichtmetallisierung durch eine dielektrische, meist oxidische Passivierungsschicht zu ersetzen, wobei die elektrische Anbindung der großflächigen Rückseitenmetallisierung an die Halbleiteroberfläche durch kleine, meist regelmäßig in Matrixpositionen angeordnete Punktkontakte (Local Back Surface Field - Local BSF) erreicht wird.

Die dabei gebildete Rückseitenkontaktstruktur findet in vielfältigen Varianten Anwendung. Zum vorgenannten Stand der Technik sei auf nachstehende Literaturstellen aufmerksam gemacht:
A.W. Blakers et al, Appl. Phys. Lett., 55 (1989), Seiten 1363 bis 1365;
G. Agostinelli et al, 20th European Photovoltaic Solar Energy Conference (2005), Barcelona, Spanien, Seite 647; und
P. Choulat et al, 22nd European Photovoltaic Solar Energy Conference (2007), Milano, Italien.

In den Schriften WO 2006/029250 A2 sowie US 2004/0200520 A1 sind ebenfalls Solarzellen beschrieben, die eine Rückseitenkontaktstruktur aufweisen. Im Herstellungsverfahren der Rückseitenkontaktstruktur ist es jedoch nicht vorgesehen, zur Bildung einer eutektischen Verbindung eine dünne Metallschicht mit einer Dickschicht aus einer leitfähigen Paste zu kombinieren.

Die am weitesten verbreiteten lokalen BSF-Kontakte sind sogenannte "Laser Fired Contacts" (LFC-Kontakte), bei denen durch Laserbeschuss die vorher aufgebrachte Metallschicht, meist als Dünnfilm-Aluminium ausgebildet, durch die Oxidschicht hindurch mit der Halbleiteroberfläche verschmolzen wird.

Ein wesentlicher Nachteil des Verfahrens der Laser-getriebenen Kontaktierung besteht darin, daß die Vielzahl der notwendigen lokalen Kontakte sequentiell und deshalb in möglichst hoher Zahl pro Sekunde und hoher Lichtintensität hergestellt werden muss. Beim hier entstehenden hochenergetischen, punktuellen Verschmelzen des Aluminiums durch die Oxidschicht hindurch findet oft eine Schädigung der Silizium-Oberfläche unter den lokalen Kontakten statt, die sich insbesondere in einer erhöhten Oberflächenrekombinationsgeschwindigkeit und damit einer reduzierten Passivierungswirkung äußert.

Aus dem Vorgenannten ist es daher Aufgabe der Erfindung, ein weiterentwickeltes Verfahren zur Herstellung einer monokristallinen Solarzelle mit einer passivierten Rückseite und einer Rückseitenkontaktstruktur anzugeben, welches eine schonende und zeitsparende Methode für die Herstellung einer Schichtkombination mit unterschiedlichen Funktionalitäten für die lokale Kontaktierung einer Solarzellenrückseite angibt.

Die Lösung der Aufgabe der Erfindung erfolgt durch die Lehre gemäß der Verfahrensabfolge nach Patentanspruch 1.

Das erfindungsgemäße Verfahren betrifft demnach eine Prozessschrittfolge für die Herstellung von lokalen Kontakten einer Metallschicht durch eine ganzflächige Passivierungsschicht einer Zellenrückseite hindurch auf die Halbleiteroberfläche, wobei in erfinderischer Weise eine Dünnschichterzeugung mit der Erzeugung einer Dickschicht durch Siebdruck oder Schablonendruck kombiniert wird. Dabei entsteht durch die erfindungsgemäße Verfahrensabfolge eine sogenannte PERC-Struktur (Passivated Emitter and Rear Cell), wobei gegenüber dem Stand der Technik wesentliche Vorteile bestehen.

Diese Vorteile zeigen sich darin, daß die Passivierungsschicht, welche gleichzeitig eine elektrische Isolation darstellt, aus einem jeweils am besten geeigneten Material und mit der jeweils geeignetsten Technologie ausgebildet werden kann. Ebenso kann diese Passivierungsschicht mit einer solchen Technologie lokal geöffnet werden, die geringste Wechselwirkungen mit den übrigen Komponenten zur Folge hat. Die Passivierungsschicht wiederum wird mit einer schonenden Technologie, insbesondere der Dünnschicht-Technologie, mit einer am besten geeigneten Metallisierung, insbesondere Aluminium bedeckt, wobei gleichzeitig mit den großen isolierten Flächen auch die lokalen Kontaktflächen auf der Halbleiteroberfläche abgedeckt werden.

Die Herstellung der lokalen BSF-Flächen aus rekristallisierendem AlSi in den lokalen Kontaktflächen wird mit dem Sintern einer Dickschichtpaste, insbesondere einer Silberpaste kombiniert, die vorab auf die lokalen Kontakte und die Außenkontaktflächen durch Drucken aufgebracht wird. Dabei wird das Schmelzen des AlSi-Eutektikums genutzt, um über dessen Reaktion mit der leitfähigen Paste, insbesondere Silberpaste, die zur Bildung von intermetallischen Phasen des Ag-Al-Systems führt, eine dauerhafte niederohmige Verbindung der Dünnschichtmetallisierung auf der Passivierungsschicht mit der lokal begrenzten BSF-Schicht im Halbleiter sicherzustellen.

Die wesentlichsten verfahrensseitigen Schritte lassen sich wie folgt zusammenfassen.

Auf ein üblicherweise vorprozessiertes Zellenmaterial erfolgt ein ganzflächiges Aufbringen einer passivierenden, dielektrischen Schicht mindestens auf der Zellenrückseite. Anschließend wird ein lokales Entfernen der passivierenden Schicht im Bereich von Busbars und Durchkontaktierungsstellen auf der Rückseite vorgenommen.

Hiernach wird die Zellenrückseite homogen beschichtet, und zwar zur Ausbildung einer unstrukturierten, dünnen Metallschicht, welche in den von der Passivierungsschicht freien Bereichen die Oberfläche des Substratmaterials, d.h. die Halbleiteroberfläche berührt.

Im Anschluss wird ein Erzeugen einer Dickschicht aus einer leitfähigen Paste im Bereich der Busbars und Durchkontaktierungsstellen vorgenommen.

Es erfolgt dann ein Sintern der Dickschicht bei einer Temperatur oberhalb einer vorgegebenen Eutektikumstemperatur und die Bildung einer eutektischen, niederohmigen Verbindung der dünnen Metallschicht mit der Oberfläche des Substratmaterials sowie mit den leitfähigen Partikeln der Dickschicht-Paste.

Die vorerwähnte Passivierungsschicht kann aus einem Siliziumoxid, Aluminiumoxid oder dergleichen Material bestehen.

Die Dünnschicht wird bevorzugt durch Sputtern oder Aufdampfen eines Aluminiummaterials erzeugt.

Auch die auf der Vorderseite notwendigen Leiterbahnen und Busbars können durch Dickschicht-Siebdruck oder Schablonendruck erzeugt werden.

Beide Dickschichten, d.h. die Dickschicht auf der Vorder- und die Dickschicht auf der Rückseite können während einer gemeinsamen Temperaturbehandlung gesintert werden.

Es werden für die Dickschichtrealisierung Pasten gewählt, die bevorzugt in einem Temperaturbereich oberhalb des Al-Si-Eutektikums von 577°C, aber unterhalb des Aluminium-Schmelzpunkts von 660°C, also bevorzugt zwischen 580°C und 620°C sinterfähig sind.

Die Erfindung soll nachstehend anhand eines Ausführungsbeispiels sowie unter Zuhilfenahme von Figuren näher erläutert werden.

Hierbei zeigen:
- Fig. 1A: eine Draufsicht einer Drei-Busbar-Standardzelle;
- Fig. 1B: einen Querschnitt durch eine Standardzelle gemäß Fig. 1A (Stand der Technik) und
- Fig. 2A bis E: Schnittdarstellungen zur Illustration der erfindungsgemäßen Verfahrensabfolge zur Herstellung der neuartigen Solarzelle mit Rückseitenkontaktstruktur (passivierte Rückseite mit lokalen Kontakten PERC).

Die Fig. 1A und 1B zeigen die Draufsicht bzw. eine Querschnittsdarstellung einer Drei-Busbar-Standardzelle aus einem p-Siliziumwafer 1 mit Busbars auf der Vorderseite 4 sowie Rückseitenbusbars 3 sowie einem die restlichen Flächen 2 seitlich der Busbars füllenden Aluminiumpastendruck, wobei sich Aluminium und Silber entlang der Kanten jedes Silberstreifens leicht überlappen (siehe Querschnitt nach Fig. 1B).

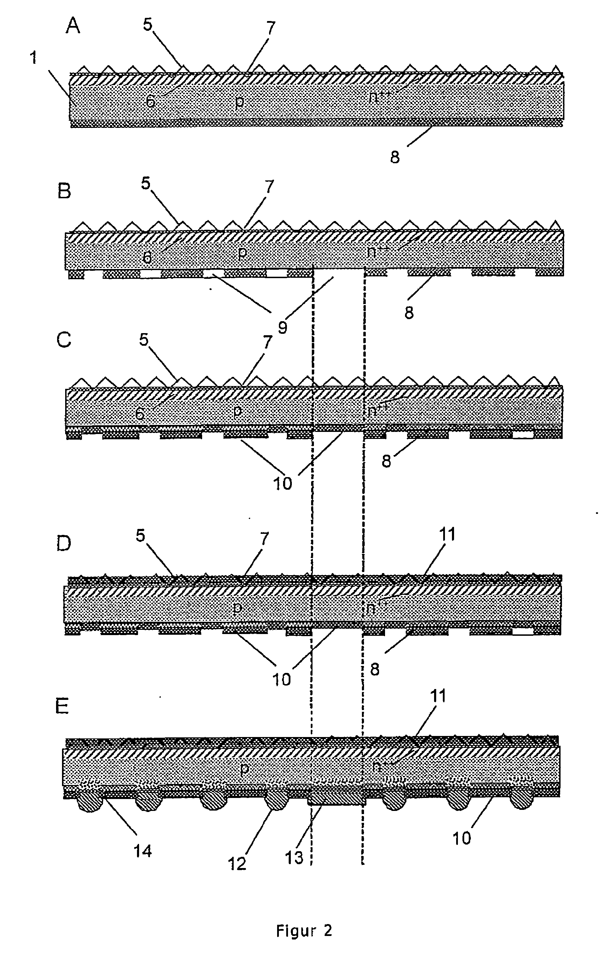

Bei dem Verfahren gemäß der Abfolge nach den Fig. 2A bis E wird in einem ersten Prozessschritt ein Abscheiden einer dielektrischen Passivierungsschicht 8, z.B. Siliziumoxid, auf der Rückseite durch z.B. thermische Oxidation, LPCVD, PECVD, Sputtern oder dergleichen vorgenommen. Die Vorderseite weist eine Vorderseitentextur 5 sowie eine Antireflexionsschicht 7 auf. Das Ausgangsmaterial 1 ist ein p-Siliziumwafer mit n⁺⁺-Emitter 6.

Wenn im ersten Schritt zur Erzeugung der Passivierungsschicht eine thermische Oxidation erfolgte, ist zusätzlich für ein Abätzen des Oxids auf der Vorderseite Sorge zu tragen.

Im Prozessschritt gemäß Fig. 2B erfolgt ein lokales Entfernen der Passivierungsschicht 8 auf der Rückseite im Bereich der Busbars und an allen lokalen Durchkontaktierungsstellen oder Durchkontaktierungspunkten 9, z.B. durch Laserablation, Drucken von Ätzpaste oder durch Plasmaätzen.

Gemäß der Darstellung nach Fig. 2C wird ein homogenes Beschichten der Rückseite mit einem leitfähigen Material, insbesondere eine Aluminiumhaltige Dünnschicht 10, durch Aufdampfen oder Sputtern ausgeführt.

Im Prozessschritt nach Fig. 2D erfolgt ein Siebdruck der Leiterbahnen und Busbars auf der Vorderseite z.B. mit Hilfe einer leitfähigen Paste, insbesondere mit Silberpaste 11.

Gemäß der Darstellung nach Fig. 2E erfolgt ebenfalls im Siebdruck das Auftragen von Durchkontaktierungspunkten 12 und der Busbars 13 auf der Rückseite der Zelle, und zwar unter Rückgriff auf Silberpastenmaterial.

In einem letzten Prozessschritt gemäß Fig. 2E erfolgt ein Sintern aller Siebdruckpasten, d.h. der ausgebildeten Bahnen auf der Vorderseite und der Durchkontaktierungspunkte 12 und Busbars 13 auf der Rückseite im Temperaturbereich zwischen 580°C und 620°C. Hierbei bildet sich aufgrund der Sintertemperatur oberhalb der Eutektikumstemperatur von 577°C ein niedrigschmelzendes AlSi-Eutektikum 14 in den Kontaktflächen zwischen dem Silizium und der Aluminiumschicht. Gleichzeitig legieren auch die Silberpartikel der Silberpaste mit dem flüssigen Aluminium-Silizium-Eutektikum, weil beim Sintern auch die Aluminium-Silber-Eutektikumstemperatur von 566°C überschritten wird.

Es wird darauf hingewiesen, dass sich die vorliegende mit ihren Verfahrensmerkmalen darstellende Erfindung auch auf sogenannte MWT-Zellen (Metal Wrap Through) erstreckt, bei denen auf der Vorderseite Emitterfinger angeordnet sind und sich Emitterbusbars auf der Rückseite befinden sowie hierbei Emitterfinger und Emitterbusbars über metallisierte, laser- oder ähnlich gebohrte Löcher in elektrischer Verbindung stehen

## Patentansprüche

1. Verfahren zur Herstellung einer monokristallinen Solarzelle mit einer passivierten Rückseite und einer Rückseitenkontaktstruktur, umfassend folgende Schritte:
- ganzflächiges Aufbringen einer passivierenden, dielektrischen Schicht (8) auf der Zellenrückseite;
- lokales Entfernen der passivierenden Schicht (8) im Bereich von Busbars (13) und lokalen Kontaktstellen (9);
- homogenes Beschichten der Zellenrückseite zur Ausbildung einer unstrukturierten, dünnen Metallschicht (10), welche in den von der Passivierungsschicht (8) freien Bereichen die Oberfläche des Substratmaterials berührt;
**dadurch gekennzeichnet, dass** zusätzlich folgende Schritte vorgesehen sind:
- Erzeugen einer Dickschicht aus einer leitfähigen Paste im Bereich der Busbars (13) und lokalen Kontaktstellen (9) und
- Sintern der Dickschicht bei einer Temperatur oberhalb einer vorgegebenen Eutektikumstemperatur und Bildung einer eutektischen, niederohmigen Verbindung (14) der dünnen Metallschicht (10) mit der Oberfläche des Substratmaterials sowie mit den leitfähigen Partikeln der Dickschicht-Paste.

2. Verfahren nach Anspruch 1,
**dadurch gekennzeichnet, dass**
die Passivierungsschicht (8) aus Siliziumoxid, Aluminiumoxid, Siliziumnitrid, Siliziumkarbid, Siliziumoxid-Siliziumnitrid-Schichtsequenzen, amorphes Silizium und Siliziumnitrid oder hinsichtlich ihrer Eigenschaften vergleichbare Materialien besteht.

3. Verfahren nach Anspruch 1 oder 2,
**dadurch gekennzeichnet, dass**
die Dünnschicht (10) durch Sputtern oder Aufdampfen insbesondere eines Aluminium-haltigen Materials gebildet wird.

4. Verfahren nach einem der vorangegangenen Ansprüche,
**dadurch gekennzeichnet, dass**
auf der Vorderseite Leiterbahnen und Busbars (4) durch Dickschicht-Siebdruck oder Schablonendruck erzeugt werden.

5. Verfahren nach einem der vorangegangenen Ansprüche,
**dadurch gekennzeichnet, dass**
die Dickschicht im Bereich der Busbars (13) und der lokalen Kontaktstellen (9) auf der Rückseite durch Siebdruck oder Schablonendruck erzeugt wird.

6. Verfahren nach Anspruch 4 und 5,
**dadurch gekennzeichnet, dass**
die Dickschichten in einem gemeinsamen Temperaturbehandlungsschritt gesintert werden.

7. Verfahren nach Anspruch 6,
**dadurch gekennzeichnet, dass**
das Sintern in einem Temperaturbereich oberhalb von 580°C, jedoch unterhalb von 660°C, vorzugsweise zwischen 580°C und 620°C durchgeführt wird.

8. Verfahren nach einem der vorangegangenen Ansprüche,
**dadurch gekennzeichnet, dass**
die leitfähige Paste (11) Silber-haltig ist.

9. Verfahren nach einem der vorangegangenen Ansprüche,
**dadurch gekennzeichnet, dass**
das Sintern der Dickschicht bei einer Temperatur oberhalb der Aluminium-Silizium-Eutektikumstemperatur von 577°C, aber unterhalb der Aluminium-Schmelztemperatur von 660°C erfolgt.

10. Solarzelle, hergestellt nach einem Verfahren gemäß einem oder mehreren der vorangegangenen Ansprüche.

## Claims

1. Method for producing a monocrystalline solar cell having a passivated rear side and a rear-side contact structure, comprising the following steps:
- applying a passivating, dielectric layer (8) over the whole area on the cell rear side;
- locally removing the passivating layer (8) in the region of busbars (13) and local contact locations (9) ;
- homogeneously coating the cell rear side in order to form an unstructured, thin metal layer (10), which touches the surface of the substrate material in the regions free of the passivation layer (8);
**characterized in that** the following steps are additionally provided:
- producing a thick layer composed of a conductive paste in the region of the busbars (13) and local contact locations (9), and
- sintering the thick layer at a temperature above a predetermined eutectic temperature and forming a eutectic, low-impedance connection (14) of the thin metal layer (10) to the surface of the substrate material and to the conductive particles of the thick layer paste.

2. Method according to Claim 1,
**characterized in that**
the passivation layer (8) consists of a silicon oxide, aluminium oxide, silicon nitride, silicon carbide, silicon oxide-silicon nitride layer sequences, amorphous silicon and silicon nitride or comparable materials with regard to their properties.

3. Method according to Claim 1 or 2,
**characterized in that**
the thin layer (10) is formed by sputtering or vapour deposition of, in particular, an aluminium-containing material.

4. Method according to any of the preceding claims,
**characterized in that**
conductor tracks and busbars (4) are produced on the front side by thick layer screen printing or stencil printing.

5. Method according to any of the preceding claims,
**characterized in that**
the thick layer is produced in the region of the busbars (13) and of the local contact locations (9) on the rear side by means of screen printing or stencil printing.

6. Method according to Claims 4 and 5,
**characterized in that**
the thick layers are sintered in a common thermal treatment step.

7. Method according to Claim 6,
**characterized in that**
the sintering is carried out in a temperature range above 580°C, but below 660°C, preferably between 580°C and 620°C.

8. Method according to any of the preceding claims,
**characterized in that**
the conductive paste (11) contains silver.

9. Method according to any of the preceding claims,
**characterized in that**
the sintering of the thick layer is effected at a temperature above the aluminium-silicon eutectic temperature of 577°C, but below the melting point of aluminium of 660°C.

10. Solar cell, produced according to a method according to one or more of the preceding claims.

## Revendications

1. Procédé de fabrication d'une cellule solaire monocristalline ayant une face arrière passivée et, sur la face arrière, une structure de contact, comprenant les étapes suivantes :
- application d'une couche diélectrique passivante (8) sur toute l'étendue de la face arrière de ladite cellule ;
- retrait localisé de la couche passivante (8) au niveau de jeux de barres (13) et de points de contact locaux (9) ;
- revêtement homogène de la face arrière de la cellule, pour ainsi former une couche mince métallique non-structurée (10) qui, dans les zones dépourvues de la couche de passivation (8), touche la surface du matériau de substrat ;
**caractérisé en ce que** l'on prévoit en outre les étapes suivantes :
- mise en place, au niveau des jeux de barres (13) et des points de contact locaux (9), d'une couche épaisse constituée d'une pâte conductrice, et
- frittage de ladite couche épaisse à une température supérieure à une température d'eutectique prédéfinie et réalisation d'un composé eutectique (14) à faible résistance ohmique que la couche mince métallique (10) forme avec la surface du matériau de substrat ainsi qu'avec les particules conductrices de ladite pâte de couche épaisse.

2. Procédé selon la revendication 1,
**caractérisé en ce que**
la couche de passivation (8) est constituée d'oxyde de silicium, d'oxyde d'aluminium, de nitrure de silicium, de carbure de silicium, de séquences de couches en oxyde de silicium et en nitrure de silicium, de silicium amorphe et de nitrure de silicium ou d'autres matériaux apparentés en ce qui concerne leurs propriétés.

3. Procédé selon la revendication 1 ou 2,
**caractérisé en ce que**
la couche mince (10) est formée par pulvérisation cathodique ou dépôt en phase vapeur, notamment d'un matériau contenant de l'aluminium.

4. Procédé selon l'une des revendications précédentes,
**caractérisé en ce que**,
sur la face avant, on réalise des circuits conducteurs et des jeux de barres (4) par sérigraphie en couche épaisse ou par impression de typon.

5. Procédé selon l'une des revendications précédentes,
**caractérisé en ce que**,
au niveau des jeux de barres (13) et des points de contacts locaux (9) sur la face arrière, ladite couche épaisse est réalisée par sérigraphie ou impression de typon.

6. Procédé selon les revendications 4 et 5,
**caractérisé en ce que**
les couches épaisses sont frittées dans une étape commune de traitement thermique.

7. Procédé selon la revendication 6,
**caractérisé en ce que**
le frittage est réalisé à des températures supérieures à 580 °C mais inférieures à 660 °C, situées de préférence entre 580 °C et 620 °C.

8. Procédé selon l'une des revendications précédentes,
**caractérisé en ce que**
la pâte conductrice (11) contient de l'argent.

9. Procédé selon l'une des revendications précédentes,
**caractérisé en ce que**
le frittage de la couche épaisse est réalisé à une température supérieure à la température d'eutectique d'aluminium-silicium, à savoir 577 °C, mais inférieure à la température de fusion de l'aluminium, à savoir 660 °C.

10. Cellule solaire, fabriquée suivant un procédé selon l'une ou plusieurs des revendications précédentes.
